**Europäisches Patentamt**

(19) **European Patent Office**

**Office européen des brevets**

(11) Veröffentlichungsnummer: **0 135 211**

**B1**

(12) **EUROPÄISCHE PATENTSCHRIFT**

(45) Veröffentlichungstag der Patentschrift:
18.05.88

(51) Int. Cl.⁴: **H 05 K 9/00**

(21) Anmeldenummer: **84201011.8**

(22) Anmeldetag: **11.07.84**

(54) Gehäuse für eine beschaltete Schaltungsplatine.

(30) Priorität: **14.07.83 DE 3325359**

(43) Veröffentlichungstag der Anmeldung:
**27.03.85 Patentblatt 85/13**

(45) Bekanntmachung des Hinweises auf die Patenterteilung:
**18.05.88 Patentblatt 88/20**

(84) Benannte Vertragsstaaten:
**DE FR GB IT**

(56) Entgegenhaltungen:
**DE-A-2 909 524**
**DE-A-2 932 015**
**DE-A-2 952 648**
**DE-B-1 938 332**
**GB-A-1 073 108**
**GB-A-2 101 811**

(73) Patentinhaber: **Philips Patentverwaltung GmbH,
Wendenstrasse 35 Postfach 10 51 49, D-2000
Hamburg 1 (DE)**

(84) Benannte Vertragsstaaten: **DE**

(73) Patentinhaber: **N.V. Philips' Gloeilampenfabrieken,
Groenewoudseweg 1, NL- 5621 BA Eindhoven (NL)**

(84) Benannte Vertragsstaaten: **FR GB IT**

(72) Erfinder: **Kupfer, Karl- Heinz, Krefelder Strasse
145, D-4150 Krefeld (DE)**
Erfinder: **Friese, Paul, Gatzenstrasse 164, D-4150
Krefeld (DE)**

(74) Vertreter: **Kupfermann, Fritz- Joachim, Dipl.- Ing.,
Philips Patentverwaltung GmbH Wendenstrasse
35 Postfach 10 51 49, D-2000 Hamburg 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Gehäuse für eine Abstimmvorrichtung für wenigstens eine beschaltete Schaltungsplatine mit flächenhaften Leitungszügen, an der beiderseits durch Anlöten elektrische Bauteile elektrisch kontaktiert angeordnet sind, wobei eine Abschirmung die Schaltungsplatine teilweise umschließt und wobei auf beiden Oberflächen der Schaltungsplatine angeordnete Schottrahmen, die mit Kanten ihrer Wände und gegebenenfalls den Innenraum aufteilenden Schottwänden frei von Schwertern senkrecht zur Platine stehen, an dieser festgelegt sind.

Derartige Abstimmvorrichtungen werden im allgemeinen als Tuner bezeichnet und sind aus der DE-A-29 32 015 bekannt. Im Laufe von verschiedenen Tuner-Generationen haben sich diese Abstimmvorrichtungen ständig verkleinert. Heute bestehen sie im allgemeinen aus einer Hartpapierplatte mit flächenhaften Leitungszügen und einer auf der Hartpapierplatte aufgebrachten Abstimmschaltung. Eine solche Schaltungsplatte ist, wie beispielsweise in der DE-GmS 82 03 769 beschrieben, von einem metallischen Schottrahmen umgeben, der die Schaltungsplatte zusammen mit Deckel bildenden Metallplatten abschließt. Innerhalb der Abschirmung sind noch einzelne Hochfrequenzräume durch Schottwände voneinander elektrisch getrennt. Die Schottwände greifen mit Schwertern in die Schaltungsplatte.

Aus der GB-A-21 01 811 ist es darüber hinaus bekannt, auf den Oberflächen einer Schaltungsplatine Gehäusewände durch Anschrauben zu befestigen, wozu es außer dem Anschraubvorgang auch nötig ist, exakt plazierte Schraublöcher vorzusehen. Die Schottwände können dann frei von Schwertern sein.

Abstimmvorrichtungen unterliegen im Wandel der Technologien einem ständigen Preisdruck. Dazu gehört die Bewältigung von Schwierigkeiten, die Toleranzen mit sich bringen. Bei keramischen Diokschichtschaltungsplatinen sind Toleranzen in den äußeren Abmessungen und dem Lochraster für die Schwerter oder Schraubenlöcher nicht vermeidbar.

Es ist Aufgabe der Erfindung, ein Gehäuse für eine weiter verkleinerte Abstimmvorrichtung zu schaffen, bei der sich Abmessungstoleranzen der Dickschichtschaltungsplatine nicht störend auswirken und die einzelnen Bauteile bis zur Endmontage des Gehäuses prüf- und abstimmbar bleiben.

Die gestellte Aufgabe ist erfindungsgemäß dadurch gelöst, daß die Schottrahmen mit ihren Kanten an Lötflächen beider Platinenoberflächen angelötet sind, daß ein Schottrahmen außerhalb von drei Seitenrändern der Schaltungsplatine angeordnet ist und sich vor diesen Seitenrändern mit dem zweiten Schottrahmen überlapt und daß die Schottrahmen im Bereich der Überlappungen vor dem Verlöten mittels Einschnappverbindungen gegenseitig verrastet sind und dabei die Schaltungsplatine zwischen sich einklemmen.

Es hat sich gezeigt, daß durch das Anlöten der Metallrahmen auf beide Oberflächen der Platine eine vollständig funktionsfähige Abstimmvorrichtung entsteht. Alle einzelnen Bauteile sind vor dem Verlöten lediglich durch die Schnappverbindung gehalten, wobei bereits ohne Schwierigkeiten die erforderlichen Abstimmungen und Abgleiche vorgenommen werden können.

Toleranzen im Rand der Schaltungsplatte werden dadurch unbeachtlich. Die Schottrahmen stehen so weit nach außen über, daß sie immer mit Luft außerhalb bleiben. Mittels der frei von Schwertern auf der Schaltungsplatte aufliegenden Schottwände können Schottrahmen und Schottwände auf der Schaltungsplatte gleichsam schwimmen, bevor sie durch das Anlöten an die flächenhaften Lötflächen der Schaltungsplatte festgelegt werden.

Nach einer weiteren Ausgestaltung der Erfindung ist vorgesehen, daß die Platine eine Dickschichtsubstratplatte ist. Ein solches Dickschichtsubstrat läßt sich sehr schwierig mit sehr exakten Abmessungen fertigen. Wenn nun die Metallrahmen an der Platine aus einer schwimmenden Lage festgelötet werden, dann kann die Platine ohne weiteres Abmessungstoleranzen aufweisen, da sie vor dem Festlöten der Metallrahmen schwimmend zwischen ihnen verschiebbar ist.

Nach einer weiteren Ausgestaltung der Erfindung ist hierzu vorgesehen, daß in den Wänden des die Platine mit den Schottrahmen umgebenden übergestülpten Umgehäuses Lötdurchbrüche vorgesehen sind, durch die die flächig nahe diesen Wänden verlaufenden Schottwände mit den Gehäusewänden verlötet sind. Ober die Lötung ist auch hier ohne Schwierigkeiten ein größerer Toleranzausgleich möglich.

Nach einer weiteren Augestaltung der Erfindung ist vorgesehen, daß ein die Anschlußstifte tragender Streifen der Platine zwischen Schottwänden der Rahmen hindurch aus dem Hochfrequenzraum nach außen ragt. Auf diese Weise wird es möglich, die Schaltungsplatine bzw. die ganze Abstimmvorrichtung von den an die Schaltungsplatine angeschlagnen Anschlußstiften tragen zu lassen. Zum sicheren Stand können zwar noch weitere Stutzfüße eingesetzt werden. Diese sind aber nicht unbedingt erforderlich. Funktionsmäßig ist diese Konstruktion besonders einfache, da alle Anschlüsse bis zu den Anschlußstiften in automatisierten Arbeitsprozessen vorgenommen werden können.

Die Erfindung wird anhand des in den Zeichnungen dargestellten Ausführungsbeispieles näher erläutert. Es zeigen:

Fig. 1 schaubildlich eine Explosionsansicht der Teile eines funktionsfähigen Zwischenbausteines einer Abstimmvorrichtung, wobei die Tauchseite oben dargetellt ist,

Fig. 2 schaubildlich die zusammengesetzte Abstimmvorrichtung nach Fig. 1,

Fig. 3 den aus einem Stück bestehenden Blechzuschnitt des Gehäuses,

Fig. 4 und 5 Darstellungen des Gehäuses, in das der Zwischenbaustein nach den Fig. 1 bis 3 eingelötet wird,

Fig. 6 eine als metallische Abschlußwand und als Typenschild dienende Aufklebfolie,

Fig. 7 eine Draufsicht auf den Zwischenbaustein nach Fig. 2 mit einer neuen Auskopplungsanordnung,

Fig. 8 und 9 den Aufbau einer kompakten Drei-Ebenen-Bauelementeanordnung auf einer Schaltungsplatine,

Fig. 10 eine vergröere Darstellung eines Schnittes X-X durch einen Rand des Zwischenbausteines vor dem Verlöten.

Im Rahmen immer kleiner werdender Peripheriegruppen an Hochfrequenzgeräten, wie beispielsweise Fernsehgeräten oder Videogeräten, ist es notwendig, die einzelnen Peripheriebaugruppen, wie auch die Abstimmvorrichtungen, in ihren Abmessungen kleiner auszulegen und dabei durch die Anwendung von automatisierbaren Arbeitsvorgängen die Herstellungskosten zu vermindern. Eine solche Abstimmvorrichtung soll beispielsweise auf die Abmessungen von etwa 51 x 34 x 12 mm begrenzt sein. In herkömmlicher Bautechnik ist bei einer derartigen Miniaturisierung Aufbau und Abgleich schwierig.

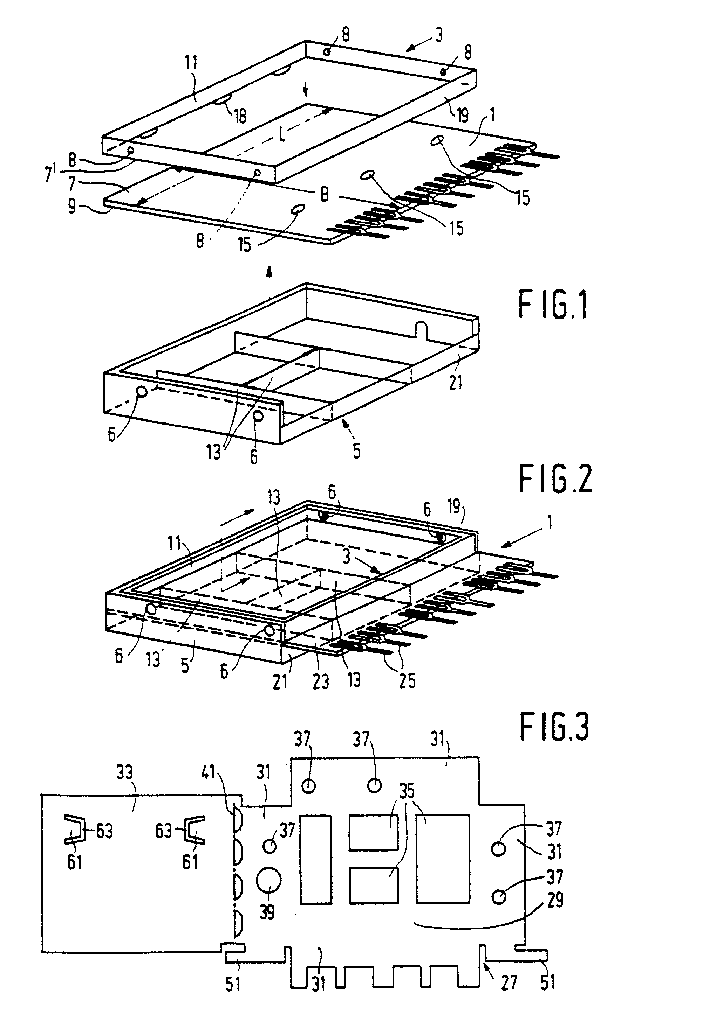

Fig. 1 zeigt in schaubildlicher Darstellung einen Zwischenbaustein, mit dem es möglich ist, schwankende Abmessungstoleranzen eines Dickschichtsubstrates 1 zuzulassen. Das Dickschichtsubstrat hat beispielsweise eine Längenabmessung L von ca. 50 mm und eine Breitenabmessung b von ca. 33 mm.

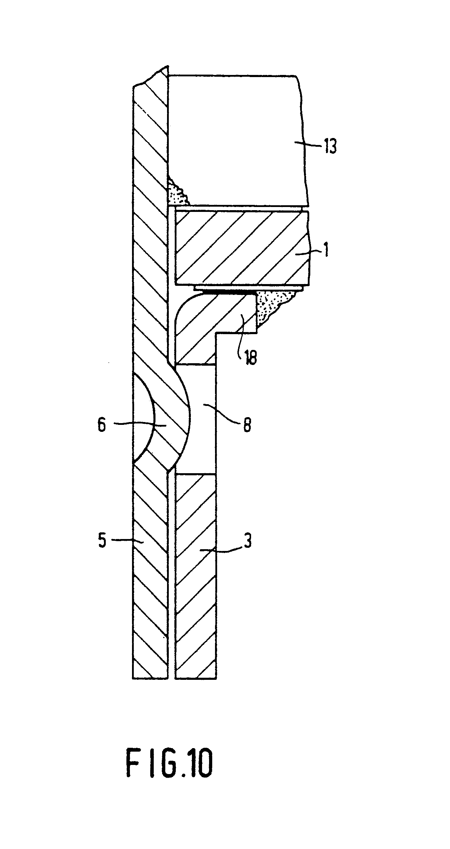

Zu dem Zwischenbaustein gehören zwei masseführende und das Umfeld abschirmende Schottrahmen 3 und 5, die flächig von der Tauchseite 7 und von der ungetauchten Seite 9 mit ebenen Kanten 8, die frei von Schwertern sind, auf das Dickschichtsubstrat auflötbar sind. Vor dem Auflöten sind Substrat 1 und Schottrahmen 3, 5 wegen der ebenen Auflage und wegen der Vermeidung der sonst üblichen Schwerter schwimmend gegeneinander verschieblich, so daß Toleranzen bequem ausgleichbar sind. Wie sich deutlich aus Fig. 2 und 10 ergibt ist der Schottrahmen 3 ein wenig kleiner als der Schottrahmen 5. Dadurch fällt der Schottrahmen 3 beim Zusammenlegen der Teile bis auf das Substrat 1 in den Schottrahmen 5 hinein, wobei dann die äußeren Ränder in einer Ebene liegen.

Die schwimmende, Toleranzen überwindende Anbringung wird noch dazu verbessert, daß Schottrahmen außerhalb von drei Seitenrändern der Schaltungsplatte angeordnet sind und sich vor diesen Seitenrändern überlappen und daß die Rahmen im Bereich der Überlappungen vor dem Verlöten mittels Einschnappverbindungen gegenseitig verrastet sind. Die Ränder der Schaltungsplatte liegen also immer frei, so daß die Plattenabmessungen schwanken können. Fig. 10 zeigt anhand einer vergrößerten Schnittdarstellung, wie die sich überlappenden Schottrahmen 3, 5 das Dickschichtsubstrat 1 zwischen sich schwimmend festklemmen und wie der Schottrahmen 5 mit einer Sicke 6 in ein Loch 8 des Schottrahmens 3 eingreift, wodurch die Schnappverbindung zustande kommt.

Auf dem Dickschichtsubstrat 1 befinden sich nicht dargestellte flächenhafte Leitungszüge, zu denen auch Leitungszüge zählen, die auf Null oder Erdungspotential liegen. Diese Leitungszüge sind teilweise bewußt so gelegt, daß sie Auflötflächen bilden, mit denen die Schottwände 11 des Schottrahmens 3 und die Schottwände 13 des Schottrahmens 5 verlötbar sind, damit diese Rahmen 3 und 5 als Abschirmung und als Masseführung dienen können. Dort, wo derartige Lötflächen aufgrund der Schaltung nicht bereit stehen, sind besondere Einzellötflächen 15 vorgesehen, mit denen die Schottrahmen 3 und 5 und das Substrat 1 verlötbar sind. Am Schottrahmen 3 können abgebogene Lappen 18 vorgesehen werden, die verbreiterte Lötflächen bilden. Die außen umlaufenden Schottwände der Schottrahmen 3 und 5 erstrecken sich je nach den Toleranzen des Dickschichtsubstrates genau oder ungefähr genau längs der Ränder des Substrates 1. Zwei Schottwände 19 und 21 der Rahmen 3 und 5 machen jedoch eine Ausnahme. Diese Schottwände 19 und 21 lassen zwischen sich einen Streifen 23 des Dickschichtsubstrates 1 aus dem Hochfrequenzraum heraustreten. An diesen Streifen 23 des Substrates sind Anschlußstifte 25 angeschlagen.

Ist das Dickschichtsubstrat 1 auf später noch zu beschreibende Weise vollständig bestückt, dann werden die Schottrahmen 3 und 5 von beiden Seiten 7 und 9 auf das Substrat 1 aufgelötet, wobei dieser Lötvorgang zusammen mit dem Anlöten der übrigen Bestückungsteile erfolgt. Dabei entsteht ein voll funktionsfähiger Zwischenbaustein, der auch ohne Gehäuse und ohne abschließende Deckel voll funktionsfähig ist. Dieser Zwischenbaustein läßt sich gut abgleichen, da alle seine Bauteile für Abgleiche und Fehlerkontrollen freiliegen.

Fig. 3 zeigt die Abwicklung des Gehäuses, in das der Zwischenbaustein nach den Fig. 1 und 2 einsetzbar ist. Diese Abwicklung besteht aus einem einzigen Blechzuschnitt, beispielsweise aus Weißblech. An diesem Blechzuschnitt 27 befinden sich der spätere Boden 29, die Gehäusewände 31 und der Gehäusedeckel 33. Im Boden 29 sind Fenster 35 vorgesehen. Die Seitenwände 31 weisen Lötdurchbrüche 37 auf, und eine der Seitenwände hat ein Antennenloch 39.

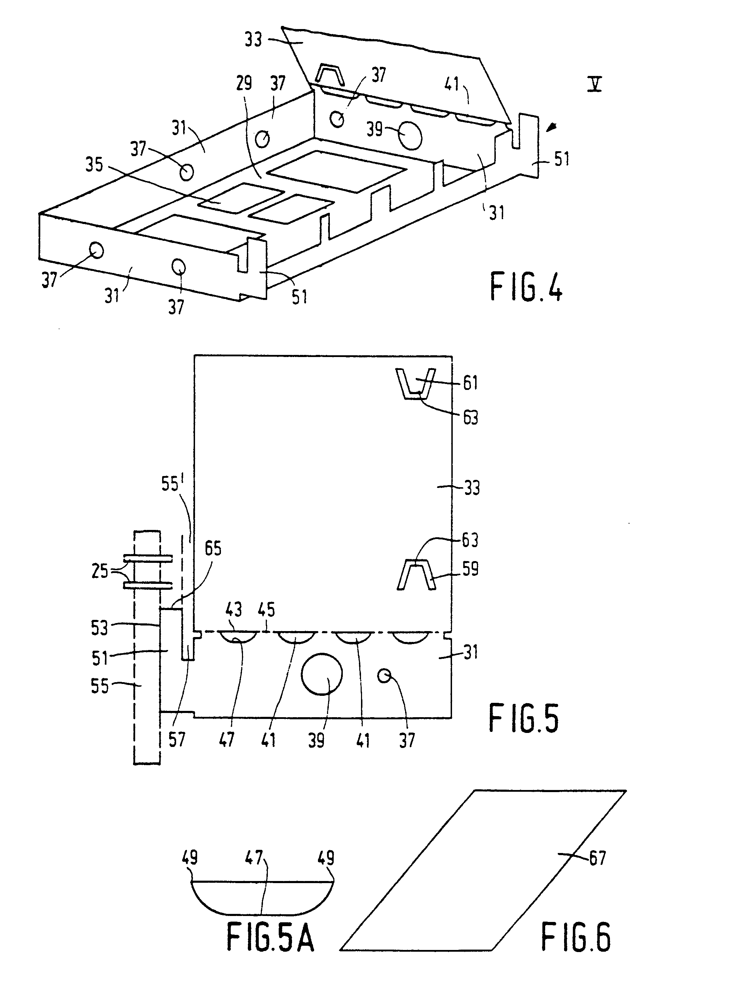

Fig. 4 zeigt nun in schaubildicher Darstellung, wie der Blechzuschnitt 27 nach Fig. 3 durch Auffalten zu einem Gehäuse wird. Am Boden 29 erkennt man die Fenster 35. In den Seitenwänden 31 befinden sich die Lötdurchbrüche 37, und der Gehäusedeckel 33 ist über Knickdurchbrüche 41 an der Gehäusewand 31 mit dem Antennendurchbruch 39 fest, jedoch abknickbar verbunden.

In Fig. 5 ist in Richtung eines Ansichtspfeiles 5 eine Ansicht des Gehäuses dargestellt, aus der besonders deutlich zu erkennen ist, wie der Gehäusedeckel 33 mit einer der Seitenwände 31 homogen verbunden ist und bleibt. Durch die Seitenwand 31 ist der Antenneneinang hindurchgeführt. Der homogene Blechübergang von Deckel über Seitenwand 31 zum Boden sorgt für eine besonders gute Freiheit von HF-Störeffekten. Die Knickdurchbrüche 41 bestehen jeweils aus einer geradlinigen Stanzkante 43, die in die Knicklinie 45 fällt. Die andere Kante des Durchbruches 41, die Bogenkante 47, ist vornehmlich im Bereich der Enden 49 der Stanzkante 43 gebogen.

An das Gehäuse sind Fußlappen 51 angeschnitten. Diese Fußlappen 51 ermöglichen es, die Abstimmvorrichtung mit einer Vorderkante 53 vertikal auf einer gestrichelt angedeuteten Schaltungsplatte 55 hochkant aufzustellen. Die Anschlußstifte 25 können dann in diese Schaltungsplatte 55 eingelötet sein. Ebenso ist es möglich, die Abstimmvorrichtung beispielsweise in eine andere Schaltungsplatte 55' einzustecken, wobei diese Schaltungsplatte 55' in vorgesehene Nuten 57 zwischen Fußlappen und Gehäusewand 31 eindringt.

Ist der Deckel 33 auf das Gehäuse aufgeschwenkt und werden durch U-förmige Ausstanzungen 59 gebildete Stützlappen 61 ausgebogen, dann kann die Abstimmvorrichtung auf den Vorderkanten 63 der Stützlappen 61 und den Vorderflächen 65 der Fußlappen 51 im Abstand von einer Schaltungsplatte auf diese aufgelötet werden.

Ist die Abstimmvorrichtung vollständig fertig abgestimmt und betriebsbereit, dann wird auf die Fenster 35 eine Metallfolie 67 aufgeklebt, die die Fenster 35 verschließt und gleichzeitig als Typenschild ausgebildet sein kann. Das restlose Verschließen der Abstimmvorrichtung und die Aufbringung eines Typenschildes lassen sich auf diese Weise sinnvoll miteinander verbinden.

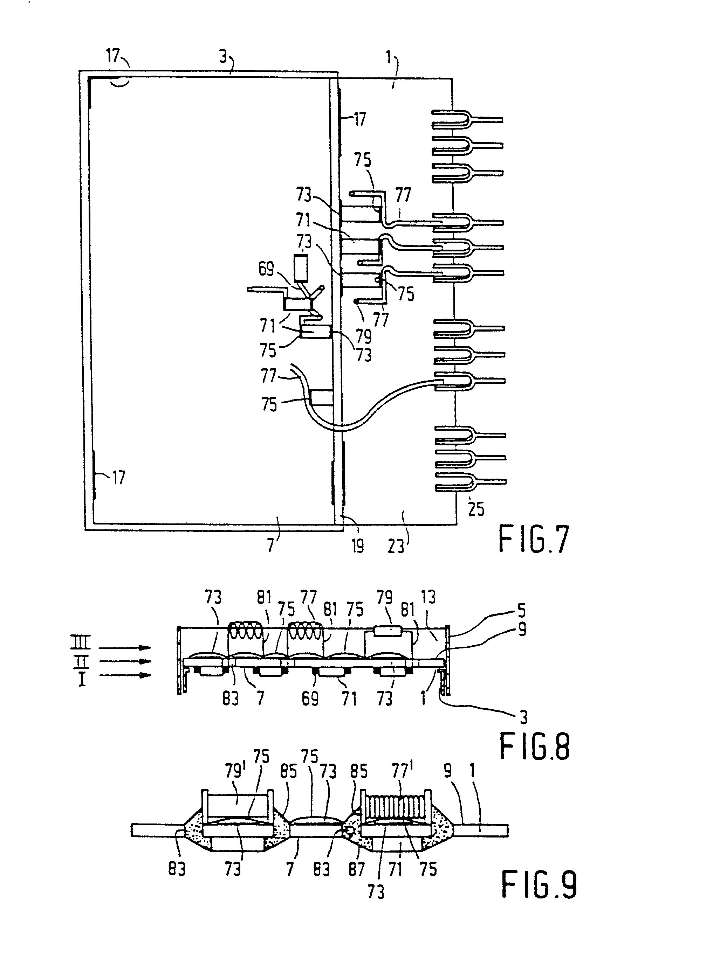

Die Fig. 7 bis 9 zeigen nun verschiedene Schaltungstechniken, mit denen es möglich ist, in möglichst gedrängter Bauweise mit einfachen Bauteilen und möglichst vollautomatisch die Schaltung des Tuners anzubringen. Das Dickschichtsubstrat 1 wird in Fig. 7 von seiner Tauchseite 7 her flächig gezeigt. Auf das Dickschichtsubstrat ist der Metallrahmen 3 aufgelötet. Lötflächen 17 sind schematisch angedeutet. Auf der Tauchseite des Substrates befinden sich im Sinterverfahren aufgebrachte Leiterbahnen 69. Die Leiterbahnen verbinden einzelne Bauteile, wie auf der Tauchseite liegende Chipschichtkondensatoren 71. Das Leitungsbild ist nicht im einzelnen aufgezeichnet, weil es für die Erklärung keine Bedeutung hat.

An den über die Schottwand 19 aus dem Hochfrequenzteil herausragenden Streifen 23 des Dickschichtsubstrates sind die Anschlußstifte 25 angeschlagen. Bei vier dieser Anschlußstifte ist dargestellt, wie die Hochfrequenzenergie aus dem Hochfrequenzraum durch die Chipschichtkondensatoren im Bereich der Streifen 25 praktisch kurzgeschlossen wird, womit zu den Anschlußstiften 25 nur Nutzsignale gelangen. Zur Auskopplung dienen Chipschichtkondensatoren 71 und die Schottwand 19. Diese Chipschichtkondensatoren 71 sind zunächst auf das Substrat 1 im üblichen Bestückungsverfahren aufgeklebt. Jeder der Chipschichtkondensatoren 71 hat zwei Kontaktflächen 73, 75. Die eine Kontaktfläche 73 ist jeweils mit der geerdeten HF-abschirmenden Schottwand 19 entweder außerhalb oder innerhalb der Schottwand 19 verlötet. Längs der anderen Kontaktfläche 75 verläuft jeweils ein auszukoppelnder Leiter 77. Um eine gute hochfrequenzmäßige Trennung herbeizuführen, verlaufen die Leiter 75 möglichst über die ganze Kontaktfläche 75 der Chipschichtkondensatoren 71 hinweg und sind durch Anlöten gut kontaktiert. Auch die Leiter 77 sind als flächenhafte Leitungszüge ausgebildet. Entweder sind sie isoliert zwischen der Schottwand 19 und der Oberfläche des Dickschichtsubstrates in den Hochfrequenzraum eingeführt oder aber durch Durchkontaktierungen auf die ungetauchte Seite 9 hindurchgezogen mittels sich durch Lotbrückendurchbrüche 83 erstreckender Lotbrücken 87 und dann auf der ungetauchten Seite in den Hochfrequenzraum eingeführt. Diese Hochfrequenzleiterauskopplungen entsprechen funktionsmäßig vollständig den üblichen Rohrdurchführungen, sind aber gegenüber diesen wesentlich wirtschaftlicher erstellbar.

Fig. 8 zeigt eine Drei-Ebenen-Anordnung von Bauteilen auf einem Dickschichtsubstrat 1, um so zu einer größeren Packungsdichte und einem vereinfachten Löten zu gelangen. Auf der Tauchseite 7 des Dickschichtsubstrates sind flächenhafte Leitungszüge 69 derart angeordnet, wie sie in Fig. 7 angedeutet sind. Die flächenhaften Leitungszüge erstrecken sich natürlich über die gesamte Tauchseite 7. Nach ihrem Aufkleben werden Chipschichtkondensatoren 71 mit den flächenhaften Leitungszügen 69 verlötet. Auf der Tauchseite 7 können auch integrierte Schaltungen angeordnet werden. In der Anordnungsebene, die in Fig. 8 mit I bezeichnet ist, ist es auf jeden Fall wichtig, daß nur beim Löten in das Lötbad tauchbare Bauelemente vorgesehen werden.

In einer Anordnungsebene II, die sich direkt auf der ungetauchten Seite 9 des Dickschichtsubstrates 1 befindet, sind wieder flächenhafte Leitungszüge im Sinterverfahren aufgetragen. Diese Leitungszüge verbinden telweise Dickschichtwiderstände 73. Die Anordnungsebene II wird geschlossen mit Hilfe einer abdeckenden isolierenden Abdeckschicht 75. Nur in der dritten Anordnungsebene befinden sich konkrete, nicht tauchfähige Bauteile, wie Spulen 77, Lackwiderstände, Dioden und weitere integrierte Schaltungen 79. Diese Bauteile haben Anschlußbeine 81, die sich durch Lotbrückendurchbrüche 83 des Dickschichtsubstrates 1 hindurch zur Tauchseite 7 erstrecken. Auf dieser Tauchseite 7 sind die Anschlußbeine 81 mit den Leitungszügen 69 auf der Tauchseite 7 verlötbar.

Das Löten der Dickschichtsubstratplatte zusammen mit den Rahmen 3 und 5 erfolgt in einem einzigen Tauchlötvorgang, ohne daß das Dickschichtsubstrat gewendet werden muß. Dies führt verfahrensmäßig zu wesentlichen Einsparungen. Das Dickschichtsubstrat wird mit seiner Tauchseite 7 in das Tauchlötbad eingetaucht. Dabei verlöten auf der Tauchseite die Kontaktflächen der Chipschichtkondensatoren 71 mit den flächenhaften Leitungszügen 69. Auch verlöten selbstverständlich eingesetzte Anschlußbeine von integrierten Schaltungen mit den flächenhaften Leitungszügen. Das Dickschichtsubstrat wird so tief getaucht, daß das Lot durch die Lotdurchbrüche 83 hindurchdringt bis auf die nicht-getauchte Oberfläche 9. Auf dieser Oberfläche können dann die von der Abdeckungsschicht 75 freien Teile der Lötflächen 17 mit den Rahmen 5 und 3 verlöten. Zum gesamten Löten ist mithin nur ein Tauchvorgang erforderlich, um alle Lötvorgänge auf beiden Seiten durchzuführen.

Fig. 9 zeigt eine Abwandlung von konkreten Bauelementen 77' und 79'. Auf der Tauchseite 7 des Dickschichtsubstrates 1 sind, wie in Fig. 8, Chipschichtkondensatoren 71 angeklebt und später angelötet. Die konkreten Bauelemente 77' und 79' haben nach Art der MELF-Technik abgewandelte Anschlüsse 85. Diese Anschlüsse 85 sind so gestaucht, daß sie nicht durch die Lotbrückendurchbrüche 83 hindurchschiebbar sind, sondern auf der nicht-getauchten Seite 9 des Dickschichtsubstrates 1 liegen bleiben. Beim Tauchen werden auch hier Lotbrücken 87 von unten nach oben durch das Dickschichtsubstrat 1 aufsteigen und auf der nicht-getauchten Seite 9 mit den gestauchten MELF-Anschlüssen verlötet. Wichtig ist dabei selbstverständlich, daß das Dickschichtsubstrat 1 so tief getaucht wird, daß genügend Lot an der nicht-getauchten Seite 9 aus den Lötdurchbrüchen 83 austreten kann, um mit den gestauchten Anschlüssen 85 zu verlöten.

Beim Tauchen des Dickschichtsubstrates 1 ergibt sich auch noch ein weiterer Vorteil bezüglich des Leitungswiderstandes der gesinterten flächenhaften Leitungszüge. Auch diese gesinterten flächenhaften Leitungszüge werden auf der Tauchseite 7 mit Lot überzogen. Dadurch wird der Leitungswiderstand dieser flächenhaften Leitungszüge geringer.

Es muß bei dem Löten selbstverständlich dafür gesorgt werden, daß die abdeckende Lackschicht 75 auf der nicht-getauchten Seite 9 die Lötflächen 17 für die Rahmen 3 und 5 nicht abdeckt, ebenso wie die Kontaktlötflächen für die konkreten Bauteile 77' und 79' mit ihren Anschlüssen in MELF-Technik zum Verlöten freiliegen müssen.

## Patentansprüche

1. Gehäuse für eine Abstimmvorrichtung mit wenigstens einer beschalteten Schaltungsplatine mit flächenhaften Leitungszügen, an der beiderseits durch Anlöten elektrische Bauteile elektrisch kontaktiert angeordnt sind, wobei eine Abschirmung die Schaltungsplatine teilweise umschließt und wobei auf beiden Oberflächen der Schaltungsplatine (1) angeordnete Schottrahmen (3, 5), die mit Kanten ihrer Wände und gegebenenfalls den Innenraum aufteilenden Schottwänden (11, 13) frei von Schwertern senkrecht zur Platine (1) stehen und an dieser festgelegt sind, dadurch gekennzeichnet, daß die Schottrahmen (3, 5) mit ihren Kanten (8) an Lötflächen (17) beider Platinenoberflächen (7, 9) angelötet sind, daß ein Schottrahmen (5) außerhalb von drei Seitenrändern der Schaltungsplatine angeordnet ist und sich vor diesen Seitenrändern mit dem zweiten Schottrahmen (3) überlappt und daß die Schottrahmen (3, 5) im Bereich der Überlappungen vor dem Verlöten mittels Einschnappverbindungen (6, 8) gegenseitig verrastet sind und dabei die Schaltungsplatine (1) zwischen sich einklemmen.

2. Gehäuse nach Anspruch 1, dadurch gekennzeichnet, daß die Platine (1) eine Dickschichtsubstratplatte ist.

3. Gehäuse nach den Ansprüchen 1 und 2, dadurch gekennzeichnet, daß die Lötflächen (17) an der Platine (1), die dem Anlöten der Rahmen dienen, wenigstens teilweise durch die Platine (1) hindurch durchkontaktiert sind.

4. Gehäuse nach Anspruch 1, dadurch gekennzeichnet, daß in den Wänden (31) des die Platine (1) mit den Schottrahmen (3, 5) umgebenden Gehäuses Lötdurchbrüche (37) vorgesehen sind, durch die die flächig nahe diesen Wänden (31) verlaufenden Schottwände (11, 13) mit den Gehäusewänden (31) verlötet sind.

5. Gehäuse nach einem oder mehreren der Ansprüche 1 bis 4, dadurch gekennzeichnet, daß ein Anschlußstifte (25) tragender Streifen (23) der Platine (1) zwischen Wänden (19, 21) der Schottrahmen (3, 5) hindurch aus dem Hochfrequenzraum nach außen ragt.

## Claims

1. A housing for a tuner for at least one wired circuit board with planar conductor tracks, at which on either side electric elements are provided by soldering so as to be electrically contacted, a shield partly surrounding the circuit board and mounting frames (3, 5) arranged on both surfaces of the circuit board (1) being fixed to the board, which mounting frames are at right angles to this board (7) with edges of their walls and separation walls (11, 13), which are free of tongues and may divide the inner space, characterized in that the mounting frames (3, 5) are soldered with their edges (8) to soldering surfaces (17) of both board surfaces (7, 9), in that a mounting frame (5) is arranged outside three side edges of the circuit board and overlaps the second mounting frame (3) in front of these side edges, and in that the mounting frames (3, 5) at the overlap area are mutually locked before the soldering operation by means of snap connections (6, 8) and clamp the circuit board (1) between them.

2. A housing as claimed in Claim 1, characterized in that the board (1) is a thick-film substrate plate.

3. A housing as claimed in Claims 1 and 2, characterized in that the soldering surfaces (17) at the board (1), which serve for soldering the frames, are contacted at least in part through the board (1).

4. A housing as claimed in Claim 1, characterized in that the walls (31) of the housing surrounding the board (1) with the mounting frames (3, 5) are provided with soldering perforations (37), through which the separation walls (11, 13) extending in a flat plane near these walls are soldered to the housing walls (31).

5. A housing as claimed in any one of Claims 1 to 4, characterized in that a strip (23) of the board (1) carrying connection pins (25) projects to the outside from the high-frequency space between walls (19, 21) of the mounting frames (3, 5).

## Revendications

1. Boîtier pour un dispositif d'accord comportant au moins une plaquette de circuit câblée avec des rubans conducteurs plats auxquels, des deux côtés, des composants électriques sont fixés en contact électrique par soudage, un blindage entourant partiellement la plaquette de circuit et des cadres de cloisonnement (3, 5) sur les deux faces de la plaquette de circuit (1), disposés perpendiculairement à celle-ci par des bords de leurs parois et, le cas échéant, par des cloisons (11, 13) qui subdivisent l'espace intérieur, sans présenter de picots, étant fixés à cette plaquette, caractérisé en ce que les cadres de cloisonnement (3, 5) sont soudés par leurs bords (8) à des surfaces de soudage (17) des deux surfaces (7, 9) de la plaquette, qu'un cadre de cloisonnement (5) est disposé extérieurement par rapport à trois bords latéraux de la plaquette de circuit et chevauche le second cadre de cloisonnement (3) devant ces bords latéraux et que les cadres de cloisonnement (3, 5) sont verrouillés réciproquement dans la zone des parties chevauchantes, avant le soudage, au moyen de jonctions à emboîtement élastique (6, 8) et enserrent ainsi la plaquette de circuit (1) entre eux.

2. Boîtier suivant la revendication 1, caractérisé en ce que la plaquette (1) est une plaquette formant substrat à couche épaisse.

3. Boîtier suivant les revendications 1 et 2, caractérisé en ce que les surfaces de soudage (17) de la plaquette (1), qui servent au soudage des cadres, sont mises en contact au moins pour partie à travers la plaquette (1).

4. Boîtier suivant la revendication 1, caractérisé en ce que dans les parois (31) du boîtier entourant la plaquette (1) sont ménagées des ouvertures de soudage (37) à travers lesquelles les cloisons (11, 13), qui s'étendent à plat à proximité immédiate de ces parois (31), sont soudées à ces parois (31) du boîtier.

5. Boîtier suivant l'une quelconque des revendications 1 à 4, caractérisé en ce qu'une bande (23) de la plaquette (1) portant des broches de connexion (25) s'étend vers l'extérieur hors de l'espace de haute fréquence entre les parois (19, 21) des cadres de cloisonnement (3, 5).

FIG.1

FIG.2

FIG.3

FIG.4

FIG.5

FIG.5A

FIG.6

FIG.7

FIG.8

FIG.9

FIG.10